# EUROPÄISCHE PATENTSCHRIFT

(11) **EP 2 582 216 B1**
(45) Veröffentlichungstag und Bekanntmachung des Hinweises auf die Patenterteilung: **30.05.2018**
(21) Anmeldenummer: 12006220.3
(22) Anmeldetag: 03.09.2012
(51) Int. Cl.: F04D 27/00, H05K 7/20, F04D 29/70

(54) **Filterlüfter für einen Schaltschrank**
Filter ventilator for a switchgear cabinet
Aérateur de filtre pour une armoire électrique

(30) Priorität: 11.10.2011 DE 202011051589 U
(43) Veröffentlichungstag der Anmeldung: 17.04.2013
(73) Patentinhaber: Rittal GmbH & Co. KG, 35745 Herborn (DE)
(72) Erfinder: Deusing, Markus, 35688 Dillenburg (DE); Malzacher, Dietrich, 35744 Hohenahr (DE); Hartmann, Dietmar, 57076 Siegen (DE)
(74) Vertreter: Angerhausen, Christoph

(56) Entgegenhaltungen:
- DE-U1-202008 006 067
- DE-U1-202009 007 956
- US-A1- 2007 152 552
- US-B1- 6 319 114

## Beschreibung

Die Erfindung geht aus von einem Filterlüfter für einen Schaltschrank und insbesondere einem Filterlüfter für die Kühlung eines Schaltschranks mit gefilterter Umgebungsluft, mit einem Gehäuse, das mindestens eine Einlassöffnung für ungefilterte Umgebungsluft und mindestens eine Auslassöffnung für gefilterte Umgebungsluft aufweist, wobei zwischen der Einlass- und der Auslassöffnung ein Luftkanal ausgebildet ist, in dem ein Lüfter und eine Filterkassette angeordnet sind, wobei die Filterkassette eine der Auslassöffnung zugewandte Warmseite des Luftkanals von einer der Einlassöffnung zugewandten Kaltseite des Luftkanals abgrenzt, wobei der Lüfter eine Regel- und Steuereinheit mit einem Temperatursensor für die Bestimmung der Lufttemperatur der Warmseite aufweist, wobei die Regel- und Steuereinheit darauf ausgelegt ist, eine Drehzahl des Lüfters in Abhängigkeit der bestimmten Temperatur nachzuregeln, wobei der Temperatursensor an einer Ausströmseite der Vorrichtung angeordnet ist. Ein derartiger Filterlüfter ist aus der DE 20 2009 007956 U1 bekannt. Einen ähnlichen Filterlüfter zeigen auch die US 2007/152552 A1 sowie die US 6,319,114 B1.

Gattungsgemäße Filterlüfter umfassen ein Gehäuse, das mindestens eine Einlassöffnung für ungefilterte Umgebungsluft und mindestens eine Auslassöffnung für gefilterte Umgebungsluft aufweist. Derartige Filterlüfter können beispielsweise als modulares Bauteil eines Schaltschranksystems ausgestaltet sein und dazu beispielsweise an der Oberseite, an der Unterseite oder auch an einer Seitenfläche bzw. der Tür eines Schaltschrankes angeordnet sein. Vorzugsweise weist das Gehäuse des Filterlüfters dazu eine Grundfläche auf, die im Wesentlichen die Geometrie einer entsprechenden Außenfläche des Schaltschrankes aufweist, mit welchem der Filterlüfter in Verbindung gebracht werden soll. Dazu kann die Auslassöffnung des Filterlüfters an der Grundfläche des Gehäuses angeordnet sein und über eine entsprechende Öffnung in der Außenseite des Schaltschrankes mit dem Innenraum des Schaltschrankes fluidisch in Verbindung gebracht werden. Es sind auch Filterlüfter bekannt, bei denen die Grundseite des Filterlüfters gerade eine Außenwand des Schaltschrankes bildet.

Zwischen der Einlass- und der Auslassöffnung des Gehäuses ist ein Luftkanal ausgebildet, in dem ein Lüfter und eine Filterkassette angeordnet sind. Dabei sind der Lüfter und die Filterkassette in dem Luftkanal derart in Reihe geschaltet, dass von dem Lüfter über die Einlassöffnung angesogene Umgebungsluft stets einen in der Filterkassette vorgesehenen Filter passieren muss, um über die Auslassöffnung in den Innenraum des Schaltschrankes zu gelangen.

Eine weitere Funktion der Filterkassette besteht darin, eine der Auslassöffnung zugewandte Warmseite des Luftkanals von einer der Eingangsöffnung zugewandten Kaltseite des Luftkanals abzugrenzen. Die Temperaturdifferenz zwischen der Warmseite und der Kaltseite kommt dadurch zustande, dass an der Kaltseite stets die Temperatur der Umgebungsluft anliegt, während die Temperatur der Warmseite von dem pro Zeiteinheit transportierten Luftvolumenstrom abhängt, wobei letzterer wiederum von der Drehzahl des Lüfters und/oder von der Verblockung des in der Filterkassette vorgehaltenen Filters abhängt. Bei gegebener Lüfterdrehzahl sinkt mit zunehmender Verblockung des Filters der pro Zeiteinheit durch den Luftkanal in den Innenraum des Schaltschrankes transportierte Luftvolumenstrom und damit erhöht sich folglich die Temperatur des Luftvolumenstromes.

Aus der DE 10 2004 013 317 B3 ist ein Filterlüfter zur Kühlung eines Schaltschrankes bekannt, bei dem ein Lüfter, eine Filterkassette und eine Regel- und Steuereinheit in einem Gehäuse untergebracht sind, das auf einen Schaltschrank aufgesetzt werden kann. Das Gehäuse ist in ein Warmluft-Austrittsgehäuse, ein Filtergehäuse mit Filterkassette und ein Lüftergehäuse mit Lüfter unterteilt, wobei das Warmluft-Austrittsgehäuse über Warmluft-Eintrittsöffnungen mit dem Innenraum des Schaltschrankes und über Luftaustrittsöffnungen mit dem Umgebungsraum des Schaltschrankes in Verbindung steht. Dabei steht das Filtergehäuse über Kaltluft-Eingangsöffiiungen mit dem Umgebungsraum des Schaltschrankes und über einen Luftkanal mit dem Lüftergehäuse in Verbindung, wobei das Lüftergehäuse über Luftaustrittsöffnungen mit dem Innenraum des Schaltschrankes in Verbindung steht.

Der vorbeschriebene Filterlüfter hat den Nachteil, dass seine Kühlleistung bei zunehmender Verblockung des Filters abnimmt, was zu einer Überhitzung der Luft im Innenraum des Schaltschranks führen kann.

Die in der DE 20 2009 007 956 U1 beschriebene Lehre versucht dieses Problem dadurch zu lösen, dass die Filterkassette einen die Lufttemperatur der aus dem Schaltschrank ausströmenden Luft messenden Temperatursensor aufweist. Dadurch wird erreicht, dass die Lüfterdrehzahl mit steigender Verblockung des Filters und damit steigender Lufttemperatur an der Warmseite erhöht werden kann.

Die aus der letztgenannten Druckschrift bekannte Lehre hat jedoch den Nachteil, dass die Drehzahlregelung des Lüfters völlig unabhängig von der Temperatur der Umgebungsluft des Schaltschrankes durchgeführt wird. Ist der Schaltschrank beispielsweise in warmen Regionen im Freien aufgestellt, kann es etwa in den heißen Sommermonaten vorkommen, dass selbst bei völlig freiem Filter bereits die Umgebungsluft eine Temperatur aufweist, welche die Steuer- und Regeleinheit fälschlicherweise davon ausgehen lässt, dass der Filter verblockt ist, woraufhin sie die Lüfterdrehzahl unnötig weit anhebt. Die überhöhte Lüfterdrehzahl führt nicht nur zu einem unnötig hohen Energieverbrauch des Filterlüfters, sondern auch dazu, dass die Filterleistung aufgrund der sich einstellenden überhöhten Luftgeschwindigkeiten im Filter nachlässt, wodurch Staub und andere Verunreinigungen in das Schaltschrankinnere getrieben werden können.

Es ist somit die Aufgabe der Erfindung, einen gattungsgemäßen Filterlüfter für einen Schaltschrank vorzuschlagen, der unabhängig von der Temperatur der Umgebungsluft des Filterlüfters eine zuverlässige Regelung der Drehzahl des Lüfters in Abhängigkeit des Verblockungsgrades des in der Filterkassette vorgehaltenen Filters ermöglicht.

Diese Aufgabe wird von einem Filterlüfter mit den Merkmalen des Anspruchs 1 gelöst. Demgemäß ist vorgesehen, dass die Regel- und Steuereinheit einen ersten und einen zweiten Temperatursensor für die Bestimmung einer Lufttemperaturdifferenz zwischen der Warmseite und der Kaltseite aufweist und darauf ausgelegt ist, die Drehzahl des Lüfters in Abhängigkeit der bestimmten Temperaturdifferenz nachzuregeln, wobei der erste Temperatursensor an einer Einströmseite der Filterkassette und der zweite Temperatursensor an einer Ausströmseite der Filterkassette angeordnet ist, und wobei die Regel- und Steuereinheit mindestens einen Sensor für die Bestimmung einer relativen Luftfeuchtigkeit an der Warmseite aufweist und darauf ausgelegt ist, über die Regelung der Lüfterdrehzahl die Lufttemperatur an der Warmseite oberhalb der Taupunkttemperatur zu halten, um die Kondensation von Feuchtigkeit im Innern des Filterlüfters zu vermeiden.

Durch diese Anordnung des ersten und des zweiten Sensors wird erreicht, dass auf besonders zuverlässige Weise die Verblockung des Filtermediums bestimmt werden kann, da bei der vorbeschriebenen Anordnung der Sensoren lediglich der Einfluss der Verblockung des Filtermediums auf die Temperaturdifferenz zwischen Kalt- und Warmseite bestimmt wird. Wird die Temperatur der Warmseite an einer Stelle gemessen, die von der Ausströmseite der Filterkassette beabstandet ist, so kann der gemessene Temperaturwert durch Wärmestrahlung beeinflusst sein, welche beispielsweise durch auf das Gehäuse einfallende Sonnenstrahlung oder die Wärmeentwicklung im Innenraum des Schaltschrankes hervorgerufen wird.

Bei dem vorgeschlagenen Filterlüfter wird die Differenz zwischen der Temperatur der Umgebungsluft und der Temperatur an der Warmseite und damit keine absoluten Temperaturen als Maß für den Verblockungsgrad des Filters in der Filterkassette und für die Nachregelung der Drehzahl des Lüfters herangezogen.

Damit weist der erfindungsgemäße Filterlüfter nicht nur die bereits beschriebenen Nachteile der aus dem Stand der Technik bekannten Vorrichtungen nicht auf. Vielmehr wird durch die Vermeidung überhöhter Lüfterdrehzahlen auch die Geräuschemission des Filterlüfters und die Filterverblockung verringert.

Bei der bevorzugten Ausführungsform ist die Regel- und Steuereinheit weiterhin darauf ausgelegt, den Lüfter abzustellen, wenn die von dem Sensor an der Kaltseite bestimmte Lufttemperatur der Lufttemperatur an der Warmseite entspricht oder diese übersteigt. Auch diese Ausführungsform wird erst dadurch möglich, dass für die Regelung der Lüfterdrehzahl nicht nur die Temperatur an der Warmseite bestimmt wird, sondern auch die Temperatur an der Kaltseite insofern in den Regel- und Steuerprozess mit einbezogen wird, als dass erfindungsgemäß eine Differenz aus beiden Werten gebildet wird.

Es ist weiterhin bevorzugt, dass der Filterlüfter eine Datenschnittstelle für den Datenaustausch zwischen der Steuer- und Regeleinheit und einer externen Vorrichtung aufweist sowie einen Speicher für die Hinterlegung von Betriebsparametern, die von der Steuer- und Regeleinheit abrufbar sind. Bei dieser Ausführungsform kann beispielweise in Abhängigkeit der in dem Schaltschrank vorgehaltenen Bauteile und deren Wärmeresistenz eine gewünschte Kühlleistung des Filterlüfters oder eine Temperatur an der Warmseite vorgegeben werden.

Es ist weiterhin bevorzugt, dass das Gehäuse eine im Wesentlichen rechteckige Grundfläche sowie zwei Einlassöffnungen aufweist, wobei die Einlassöffnungen an gegenüberliegenden Seitenwänden des Gehäuses, die eine erste und eine zweite Stirnseite des Gehäuses miteinander verbinden, angeordnet sind und wobei die Auslassöffnung an der Grundfläche angeordnet ist. Bei dieser Ausfuhrungsform ist vorzugsweise weiterhin vorgesehen, dass die Filterkassette an die erste Stirnseite sowie an die gegenüberliegenden Seitenwände fluidisch dicht angrenzt und dabei beide Einlassöffnungen gehäuseinnenseitig vollständig überdeckt. Dabei soll eine Ausströmseite des Lüfters mit der Auslassöffnung für die gefilterte Umgebungsluft fluidisch verbunden sein und der Lüfter an seiner Saugseite ein Luftleitblech aufweisen, dass sich zwischen den gegenüberliegenden Seitenwänden sowie zwischen der Filterkassette und der zweiten Stirnseite erstreckt. Bei dieser Ausführungsform wird mit Hilfe der Filterkassette bereits in weiten Teilen des Gehäuses die für die Gestaltung gattungsgemäßer Filterlüfter notwendige Zweiteilung des Gehäuses in eine Warmseite und eine Kaltseite bereitgestellt. Bevorzugt weist dabei das Luftleitblech einen fluidischen Übergang zu der Saugseite des Lüfters auf, wobei das Luftleitblech die Saugseite des Lüfters von der Kaltseite fluidisch abtrennt, so dass die Saugseite des Lüfters nur mit der Warmseite fluidisch in Verbindung steht.

Weitere Einzelheiten der Erfindung werden anhand der nachstehenden Figuren erläutert. Dabei zeigt:
- Figur 1: eine erste Explosionsansicht einer ersten Ausführungsform des erfindungsgemäßen Filterlüfters;
- Figur 2: eine zweite Explosionsansicht auf den Filterlüfter gemäß Figur 1; und
- Figur 3: eine Querschnittsansicht des Filterlüfters gemäß den Figuren 1 und 2, der auf der Oberseite eines Schaltschrankes aufgesetzt ist.

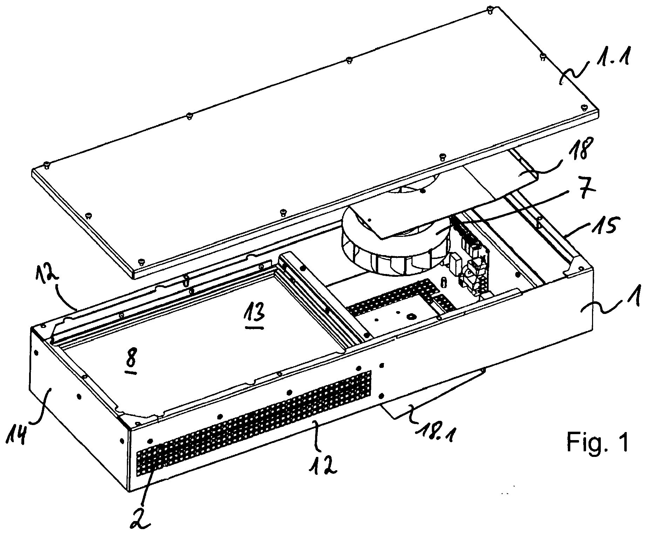

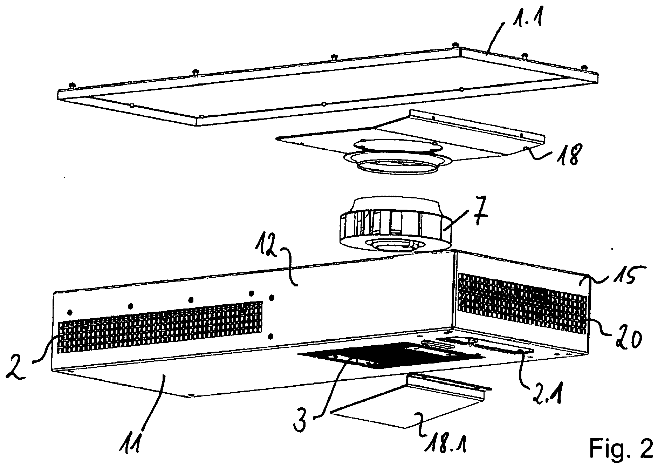

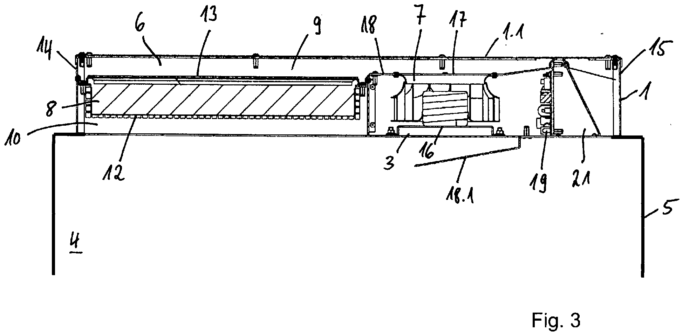

Die Figuren 1 bis 3 zeigen drei Ansichten einer bevorzugten Ausführungsform der Erfindung. Der dargestellte Filterlüfter umfasst ein Gehäuse 1, mit einem Gehäusedeckel 1.1, wobei das Gehäuse an den gegenüberliegenden Längsseiten 12 jeweils eine Einlassöffnung 2 für ungefilterte Umgebungsluft und an seiner Grundfläche 11 eine Auslassöffnung 3 für gefilterte Umgebungsluft aufweist. Die Auslassöffnung 3 ist so angeordnet, dass sie beispielsweise durch einfaches Aufsetzen des Filterlüfters auf einen Schaltschrank über einen entsprechenden Durchlass in dem Schaltschrank mit dem Innenraum des Schaltschranks fluidisch in Verbindung gebracht werden kann. Ein Luftleitblech 18.1 ist dazu vorgesehen, die aus der Auslassöffhung 3 ausströmende Luft derart umzulenken, dass sie nicht unmittelbar nach dem Austreten aus der Auslassöffnung 3 durch die Einlassöffnung 2.1 in das Warmluft-Austrittsgehäuse 21 ein- und damit aus dem Innenraum 4 des Schaltschranks 5 wieder austritt. Zwischen der Einlass- und der Auslassöffnung ist ein Luftkanal 6 ausgebildet, in dem ein Lüfter 7 und eine Filterkassette 8 angeordnet sind. Die Filterkassette 8 grenzt eine der Auslassöffhung 3 zugewandte Warmseite 9 des Luftkanals 6 von einer der Einlassöffnung 2 zugewandten Kaltseite 10 des Luftkanals 6 ab. Die Regel- und Steuereinheit ist vorliegend auf der Steuerplatine 19 ausgebildet. Diese soll erfindungsgemäß einen oder mehrere Sensoren für die Bestimmung einer Lufttemperaturdifferenz zwischen der Warmseite 9 und der Kaltseite 10 aufweisen. In Abhängigkeit der bestimmten Temperaturdifferenz zwischen der Warmseite 9 und der Kaltseite 10 soll die Regel- und Steuereinheit eine Drehzahl des Lüfters 7 derart nachregeln, dass auch bei zunehmender Verblockung des Filters ein ausreichender Luftvolumenstrom durch den Filter hindurch in den Innenraum 4 des Schaltschrankes 5 zur Kühlung der darin enthaltenen Komponenten eintritt.

Es ist weiterhin zu erkennen, dass das Gehäuse eine im Wesentlichen rechteckige Grundfläche 11 aufweist. Die gegenüberliegenden Seitenwände 12 des Gehäuses 1 verbinden eine erste und eine zweite Stirnseite 14, 15 des Gehäuses 1 miteinander. Die Filterkassette 8 grenzt sowohl an die erste Stirnseite 14 als auch an die gegenüberliegenden Seitenwände 12 fluidisch dicht an und überdeckt dabei beide Einlassöffnungen 2 gehäuseinnenseitig vollständig. Eine Ausströmseite 16 des Lüfters 7 ist mit der Auslassöffnung 3 fluidisch verbunden. Der Lüfter weist an seiner Saugseite 17 ein Luftleitblech 18 auf, das sich zwischen den gegenüberliegenden Seitenwänden 12 sowie zwischen der Filterkassette 8 und der zweiten Stirnseite 15 erstreckt.

Das Luftleitblech 18 weist einen fluidischen Übergang zu der Saugseite 17 des Lüfters 7 auf. Das Luftleitblech 18 ist weiterhin derart ausgestaltet, dass es die Saugseite 17 des Lüfters 7 von der Kaltseite 10 fluidisch abtrennt, so dass die Saugseite 17 des Lüfters nur mit der Warmseite 9 fluidisch in Verbindung steht.

Durch die Einlassöffnungen 2 für ungefilterte Umgebungsluft in das Gehäuse 1 eintretende Umgebungsluft durchdringt, nachdem sie die Kaltseite 10 des Luftkanals 6 durchströmt hat, die Filterkassette 8 durch die Einströmseite 12 der Filterkassette 8 hindurch. An der Ausströmseite 13 der Filterkassette 8 tritt die gefilterte Luft aus der Filterkassette 8 heraus und hat damit die Warmseite 9 des Luftkanals 6 erreicht. An der Warmseite 9 ist der Luftkanal 6 durch die Stirnseiten 14, 15, den Gehäusedeckel 1.1, die Ausströmseite 13 der Filterkassette 8 sowie durch das Luftleitblech 18 begrenzt. Über den fluidischen Übergang, der in dem Luftleitblech 18 zu dem Radialventilator 7 ausgebildet ist, kann die gefilterte Luft durch den Radialventilator hindurch nach Passieren dessen Ansaugseite 17 durch die Ausströmseite 16 hindurch die Auslassöffnung 3 des Gehäuses 1 erreichen und von dort in das Gehäuseinnere 4 des Schaltschrankes 5 weitergeleitet werden. Nachdem die gefilterte Luft im Gehäuseinnern 4 von der Abwärme, die von den in dem Schaltschrank 5 vorgehaltenen Komponenten abgestrahlt wird, aufgewärmt worden ist, kann sie durch das Warmluft-Austrittsgehäuse 21, welches ein integraler Bestandteil des Gehäuses 1 ist, durch eine Auslassöffnung 20 aus dem Schaltschrank ausgetrieben werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Filterlüfter für einen Schaltschrank, mit einem Gehäuse (1), das mindestens eine Einlassöffhung (2) für ungefilterte Umgebungsluft und mindestens eine Auslassöffnung (3) für gefilterte Umgebungsluft aufweist, wobei zwischen der Einlass- und der Auslassöffhung ein Luftkanal (6) ausgebildet ist, in dem ein Lüfter (7) und eine Filterkassette (8) angeordnet sind, wobei die Filterkassette (8) eine der Auslassöffnung (3) zugewandte Warmseite (9) des Luftkanals (6) von einer der Einlassöffnung (2) zugewandten Kaltseite (10) des Luftkanals (6) abgrenzt, wobei der Lüfter (7) eine Regel- und Steuereinheit mit einem ersten und einem zweiten Temperatursensor für die Bestimmung einer Lufttemperaturdifferenz zwischen der Warmseite (9) und der Kaltseite (10) aufweist, wobei die Regel- und Steuereinheit darauf ausgelegt ist, eine Drehzahl des Lüfters (7) in Abhängigkeit der bestimmten Temperaturdifferenz nachzuregeln, wobei der erste Temperatursensor an einer Einströmseite (12) der Filterkassette (8) und der zweite Temperatursensor an einer Ausströmseite (13) der Filterkassette (8) angeordnet ist, und wobei die Regel- und Steuereinheit mindestens einen Sensor für die Bestimmung einer relativen Luftfeuchtigkeit an der Warmseite (9) aufweist und darauf ausgelegt ist, über die Regelung der Lüfterdrehzahl die Lufttemperatur an der Warmseite (9) oberhalb der Taupunkttemperatur zu halten, um die Kondensation von Feuchtigkeit im Innern des Filterlüfters zu vermeiden.

2. Filterlüfter nach Anspruch 1, **dadurch gekennzeichnet, dass** die Regel- und Steuereinheit darauf ausgelegt ist, den Lüfter (7) abzustellen, wenn die von dem Sensor an der Kaltseite (10) bestimmte Lufttemperatur der Lufttemperatur an der Warmseite (9) entspricht oder diese übersteigt.

3. Filterlüfter nach einem der vorangegangenen Ansprüche, **dadurch gekennzeichnet, dass** der Filterlüfter eine Datenschnittstelle für den Datenaustausch zwischen der Steuer- und Regeleinheit und einer externen Vorrichtung aufweist sowie einen Speicher für die Hinterlegung von Betriebsparametern, die von der Steuer- und Regeleinheit abrufbar sind.

4. Filterlüfter nach einem der vorangegangenen Ansprüche, **dadurch gekennzeichnet, dass** das Gehäuse (1) eine im Wesentlichen rechteckige Grundfläche (11) sowie zwei Einlassöffnungen (2) aufweist, wobei die Einlassöffnungen (2) an gegenüber liegenden Seitenwänden (12) des Gehäuses (1), die eine erste und eine zweite Stirnseite (14, 15) des Gehäuses (1) miteinander verbinden, angeordnet sind und wobei die Auslassöffnung (3) an der Grundfläche (11) angeordnet ist.

5. Filterlüfter nach Anspruch 4, **dadurch gekennzeichnet, dass** die Filterkassette (8) an die erste Stirnseite (14) sowie an die gegenüber liegenden Seitenwände (12) fluidisch dicht angrenzt und dabei beide Einlassöffnungen (2) gehäuseinnenseitig überdeckt, wobei eine Ausströmseite (16) des Lüfters (7) mit der Auslassöffnung (3) fluidisch verbunden ist, und wobei der Lüfter (7) an seiner Saugseite (17) ein Luftleitblech (18) aufweist, das sich zwischen den gegenüber liegenden Seitenwänden (12) sowie zwischen der Filterkassette (8) und der zweiten Stirnseite (15) erstreckt.

6. Filterlüfter nach Anspruch 5, **dadurch gekennzeichnet, dass** das Luftleitblech (18) einen fluidischen Übergang zu der Saugseite (17) des Lüfters (7) aufweist, wobei das Luftleitblech (18) die Saugseite (17) des Lüfters (7) von der Kaltseite (10) fluidisch abtrennt, so dass die Saugseite (17) des Lüfters (7) nur mit der Warmseite (9) fluidisch in Verbindung steht.

## Claims

1. Filter fan for a switch cabinet, having a housing (1) which has at least one inlet opening (2) for unfiltered ambient air and at least one outlet opening (3) for filtered ambient air, wherein between the inlet and the outlet openings (2, 3) an air duct (6) is formed in which a fan (7) and a filter cassette (8) are arranged, the filter cassette (8) delimiting a warm side (9) of the air duct (6) facing the outlet opening (3) from a cold side (10) of the air duct (6) facing the inlet opening (2), the fan (7) comprising a control and regulation unit having first and second temperature sensors for determining an air temperature difference between the warm side (9) and the cold side (10), the control and regulation unit being adapted to readjust a speed of the fan (7) depending on the determined temperature difference, the first temperature sensor being arranged at an inlet side (12) of the filter cassette (8) and the second temperature sensor being arranged at an outlet side (13) of the filter cassette (8), and wherein the control and regulation unit comprises at least one sensor for determining a relative air humidity on the warm side (9) and is designed to maintain the air temperature on the warm side (9) above the dew point temperature by controlling the fan speed in order to avoid condensation of moisture inside the filter fan.

2. Filter fan according to claim 1, **characterised in that** the control and regulation unit is designed to switch off the fan (7) when the air temperature determined by the sensor on the cold side (10) corresponds to or exceeds the air temperature on the warm side (9).

3. Filter fan according to one of the preceding claims, **characterised in that** the filter fan has a data interface for data exchange between the control and regulating unit and an external device, and a memory for storing operating parameters which can be called up by the control and regulating unit.

4. Filter fan according to one of the preceding claims, **characterised in that** the housing (1) has a substantially rectangular base surface (11) and two inlet openings (2), the inlet openings (2) being arranged on opposite side walls (12) of the housing (1) connecting a first and a second end face (14, 15) of the housing (1), and the outlet opening (3) being arranged on the base surface (11).

5. Filter fan according to claim 4, **characterised in that** the filter cassette (8) is fluidically tightly adjacent to the first end face (14) and to the opposite side walls (12) and thereby covers both inlet openings (2) on the inside of the housing, wherein an outlet side (16) of the fan (7) is fluidically connected to the outlet opening (3), and wherein the fan (7) has on its suction side (17) an air baffle (18) extending between the opposite side walls (12) and between the filter cassette (8) and the second end face (15).

6. Filter fan according to claim 5, **characterised in that** the air baffle (18) has a fluidic transition to the suction side (17) of the fan (7), wherein the air baffle (18) fluidically separates the suction side (17) of the fan (7) from the cold side (10) so that the suction side (17) of the fan (7) only communicates fluidically with the warm side (9).

## Revendications

1. Ventilateur à filtre pour une armoire de commande, avec un boîtier (1), qui comprend au moins une ouverture d'entrée (2) pour l'air ambiant non filtré et au moins une ouverture de sortie (3) pour l'air ambiant filtré, moyennant quoi, entre l'ouverture d'entrée et l'ouverture de sortie, est formé un canal d'air (6), dans lequel un ventilateur (7) et une cartouche filtrante (8) sont disposés, la cartouche filtrante (8) séparant un côté chaud (9), orientée vers l'ouverture de sortie (3), du canal d'air (6), d'un côté froid (10) orienté vers l'ouverture d'entrée (2), du canal d'air (6), le ventilateur (7) comprenant une unité de régulation et de commande avec un premier et un deuxième capteur de température pour la détermination d'une différence de température de l'air entre le côté chaud (9) et le côté froid (10), l'unité de régulation et de commande étant conçue pour réguler une vitesse de rotation du ventilateur (7) en fonction de la différence de température déterminée, le premier capteur de température étant disposé sur un côté d'entrée (10) de la cartouche filtrante (8) et le deuxième capteur de température étant disposé sur un côté de sortie (13) de la cartouche filtrante (8), et l'unité de régulation et de commande comprenant au moins un capteur pour la détermination d'une humidité relative de l'air au niveau du côté chaud (9) et étant conçue pour maintenir, grâce à la régulation de la vitesse de rotation du ventilateur, la température de l'air au niveau du côté chaud (9) au-dessus de la température du point de rosée, afin d'éviter la condensation de l'humidité à l'intérieur du ventilateur à filtre.

2. Ventilateur à filtre selon la revendication 1, **caractérisé en ce que** l'unité de régulation et de commande est conçue pour arrêter le ventilateur (7) lorsque la température de l'air déterminée par le capteur au niveau du côté froid (10) atteint ou dépasse la température de l'air au niveau du côté chaud (9).

3. Ventilateur à filtre selon l'une des revendications précédentes, **caractérisé en ce que** le ventilateur à filtre comprend une interface de données pour l'échange de données entre l'unité de régulation et de commande et un dispositif externe ainsi qu'une mémoire pour l'enregistrement de paramètres de fonctionnement qui peuvent être appelés par l'unité de régulation et de commande.

4. Ventilateur à filtre selon l'une des revendications précédentes, **caractérisé en ce que** le boîtier (1) comprend une surface de base (11) globalement rectangulaire ainsi que deux ouvertures d'entrée (2), les ouvertures d'entrée (2) étant disposées au niveau de parois latérales opposées (12) du boîtier (1), qui relient entre eux un premier et un deuxième côté frontal (14, 15) du boîtier (1) et l'ouverture de sortie (3) étant disposée sur la surface de base (11).

5. Ventilateur à filtre selon la revendication 4, **caractérisé en ce que** la cartouche filtrante (8) jouxte de manière étanche et fluidique le premier côté frontal (14) ainsi que les parois latérales opposées (12) et recouvre les deux ouvertures d'entrée (2) à l'intérieur du boîtier, un côté de sortie (16) du ventilateur (7) étant relié de manière fluidique avec l'ouverture de sortie (3) et le ventilateur (7) comprenant au niveau de son côté d'aspiration (17) un déflecteur d'air (18) qui s'étend entre les parois latérales opposées (12) ainsi qu'entre la cartouche filtrante (8) et le deuxième côté frontal (15).

6. Ventilateur à filtre selon la revendication 5, **caractérisé en ce que** le déflecteur d'air (18) présente une transition fluidique avec le côté d'aspiration (17) du ventilateur (7), le déflecteur d'air (18) séparant de manière fluidique le côté d'aspiration (17) du ventilateur (7) du côté froid (10) de façon à ce que le côté d'aspiration (17) du ventilateur (7) soit en relation fluidique uniquement avec le côté chaud (9).
